# FASCICULE DE BREVET EUROPEEN

(11) **EP 1 387 270 B1**
(45) Date de publication et mention de la délivrance du brevet: **22.10.2008**
(21) Numéro de dépôt: 03291227.1
(22) Date de dépôt: 23.05.2003
(51) Int. Cl.: G06F 11/26

(54) **Procédé et système de reconnaissance automatique de configurations de simulations d'un circuit intégré**
Verfahren und System zur automatischen Erkennung der Konfigurationen der Simulationen einer integrierten Schaltung
Method and system for automatic recognition of simulation configurations of an integrated circuit

(30) Priorité: 30.07.2002 FR 0209689
(43) Date de publication de la demande: 04.02.2004
(73) Titulaire: BULL SAS, 78340 Les Clayes sous Bois (FR)
(72) Inventeur: Wozniak, Andrzej, 91120 Palaiseau (FR)
(74) Mandataire: Pellegrini, Marie Claude

(56) Documents cités:
- US-A- 5 732 247
- US-A- 5 748 875
- US-A1- 2002 073 375

## Description

L'invention concerne un procédé et un système de reconnaissance automatique de configurations de simulation pour la vérification fonctionnelle des circuits intégrés ASIC par des tests de simulation. Plus particulièrement, l'invention concerne un procédé de reconnaissance automatique de configurations de simulation et un système permettant de mettre en oeuvre le procédé.

Actuellement, plusieurs brevets (US5,748,875, US5,732,247) ou demandes de brevet (US2002/0073375) proposent des systèmes qui permettent de tester des modèles simulés de dispositifs et traitant notamment des configurations de systèmes faisant intervenir des modèles écrits en langage de description du matériel, par exemple de type HDL (les langages VHDL et Verilog étant les plus utilisés), et/ou en langage de haut niveau, par exemple de type HLL (tels que C ou C++). Ces langages décrivent alors, d'une part, les éléments constitutifs du matériel et, d'autre part, les modèles constitutifs de l'environnement de simulation. Cependant, avec l'accroissement de la complexité des systèmes matériels (hardware), il faut pouvoir traiter des configurations de systèmes rassemblant de plus en plus de modèles écrits dans ces langages.

Dans la suite de la description, nous appellerons "configuration de simulation" ou "configuration" un ensemble de modèles logiciels d'éléments dits "composants" constituant un modèle global de simulation, les composants étant connectés entre eux, soit directement, soit par l'intermédiaire de blocs intermédiaires.

L'invention est utile dans la vérification de la conception des ASICs par simulation de leur fonctionnement, par exemple, dans un environnement identique à ou très proche de leur utilisation finale, le procédé de reconnaissance automatique de configurations permettant à des tests d'identifier les composants d'une configuration.

Dans le cas d'un ASIC contenant beaucoup d'éléments et étant connecté à plusieurs circuits externes, il est difficile de prévoir à l'avance toutes les configurations utiles et d'établir les relations entre les ensembles de configurations associant différentes propriétés de configuration, et les ensembles de test qui leur sont applicables. De ce fait, on renonce souvent à l'utilisation de certaines variantes de configurations facilitant le debug, ces variantes pouvant ne concerner qu'une partie des composants afin de simuler une partie seulement de l'ASIC ou de son environnement.

Pour couvrir l'ensemble des variantes d'une configuration de simulation, il est nécessaire de disposer d'une grande quantité de variantes de tests propres à chaque configuration. Cette situation est une source potentielle d'erreurs car chaque modification et correction d'un test doit être répertoriée et vérifiée dans chaque variante du test.

Le but de la présente invention vise donc à limiter les inconvénients de mise au point des programmes de test en fonction des configurations de simulation disponibles.

Ce but est atteint par un procédé de reconnaissance automatique de configurations de simulation disponibles de circuits intégrés en projet selon la revendication 1.

Selon une autre particularité, les configurations de simulation sont générées à partir des données de génération de configurations, avant l'utilisation du procédé selon l'invention.

Selon une autre particularité, la génération des configurations est réalisée par un opérateur humain.

Selon une autre particularité, la génération des configurations est réalisée par un générateur automatique de configurations.

Selon une autre particularité, l'étape d'envoi d'une requête est suivie d'une étape de traduction de ladite requête, par une interface programmatique, en langage compréhensible par le premier gestionnaire, et en ce que l'étape d'envoi d'une réponse est suivie d'une étape de traduction de ladite réponse, par l'interface programmatique, en langage compréhensible par le deuxième gestionnaire.

Selon une autre particularité, le procédé de reconnaissance automatique de configurations fonctionne dans une architecture client-serveur, le premier gestionnaire étant situé sur le serveur et le deuxième gestionnaire sur le client.

Un autre but de l'invention est de proposer un système permettant de mettre en oeuvre le procédé selon l'invention.

Ce but est atteint par un système de reconnaissance de configurations de simulation disponibles de circuits intégrés en projet selon la revendication 7.

Selon une autre particularité, le deuxième gestionnaire est muni de moyens pour inhiber, activer et/ou modifier certaines parties du test pour adapter le test en fonction de la réponse.

L'invention sera mieux comprise à l'aide de la description suivante d'un mode préféré de mise en oeuvre du procédé de l'invention, en référence aux dessins annexés, sur lesquels :
- la figure 1 représente, sous forme très schématique, un exemple de modèle global de simulation ;
- la figure 2 représente un diagramme illustrant les différentes composantes du système de reconnaissance automatique et les étapes de mise en oeuvre de ces composantes dans le procédé de l'invention ;
- les figures 3a à 3c représentent différents stades de modélisation d'un circuit à l'aide d'un modèle mixte de type HDL (VERILOG ou VHDL) et de type HLL (C++) ;
- les figures 4a à 4c représentent différentes configurations du modèle global de simulation correspondant à l'architecture représentée sur la figure 1.

Un modèle global de simulation est typiquement composé d'un ou plusieurs modèles de circuits intégrés testés (DUT) entourés de modèles qui créent un environnement de test et vérification. Ces modèles créent des stimuli complexes et reçoivent des réponses complexes du modèle testé. Ces composants peuvent être des transactors (XACTORS) - des modèles possédant généralement une interface programmatique (API) permettant un pilotage par des tests externes au modèle, ces tests étant écrits généralement en langage de haut niveau (HLL).

L'environnement de vérification peut contenir aussi des composants dits Bloc de Monitoring (MONITOR) et des composants dits Bloc de Vérification (VERIFIER). Ces composants n'interviennent pas directement dans l'échange de signaux entre les autres constituants du modèle global de simulation mais servent à les observer et à les interpréter. Les Blocs de Monitoring (MONITOR) servent de support d'analyse pour les tests, ils possèdent des interfaces programmatiques (API) pour signaler des événements observés sur les signaux de modèle global. Les Blocs de Vérification (VERIFIER) sont des composants qui possèdent une spécification de référence de fonctionnement de modèle testé et, en observant les signaux du modèle global de simulation, sont capables de vérifier le bon fonctionnement du modèle.

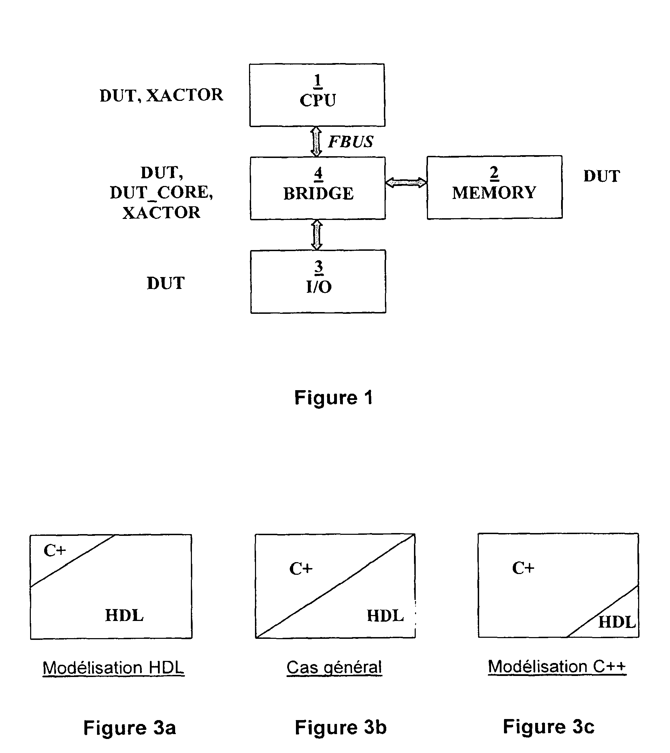

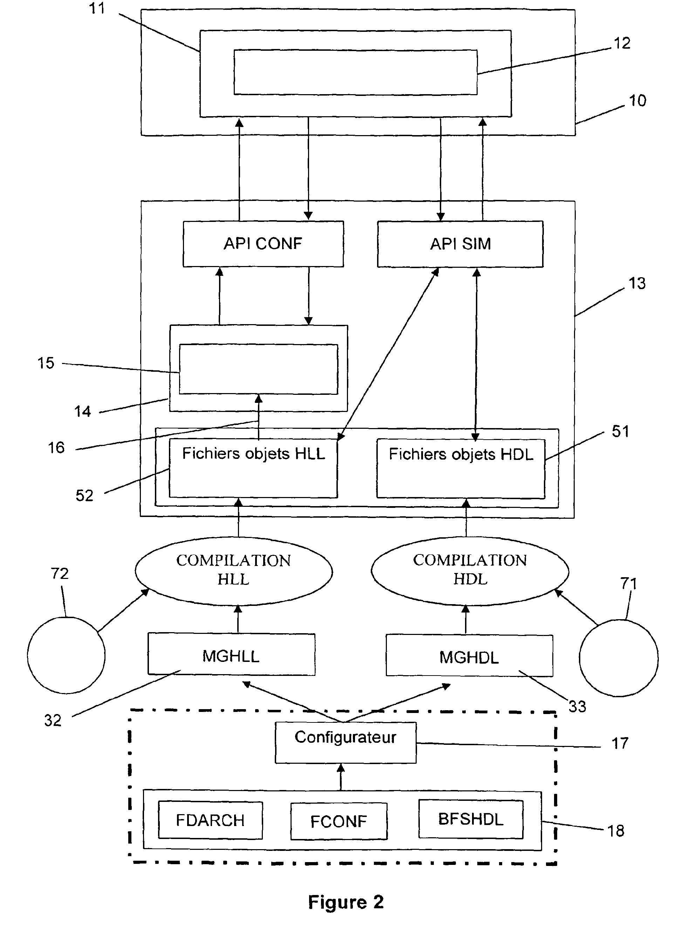

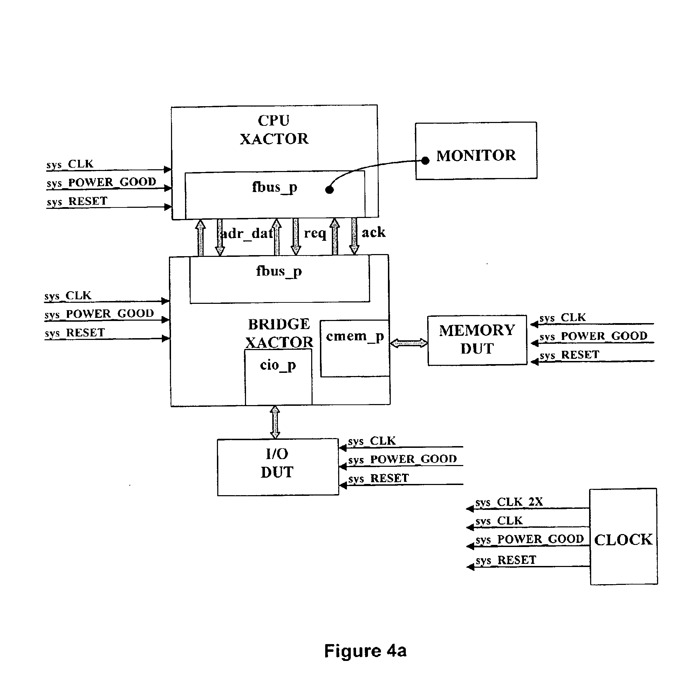

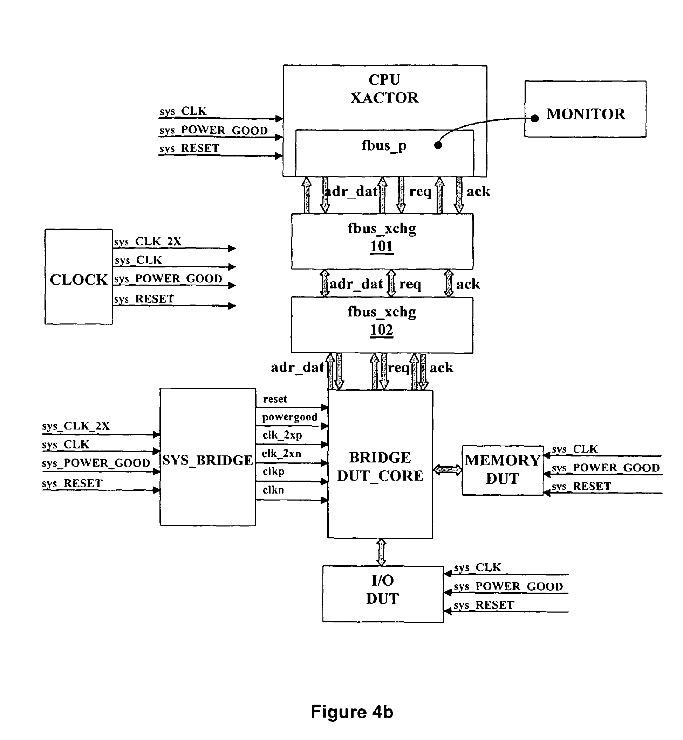

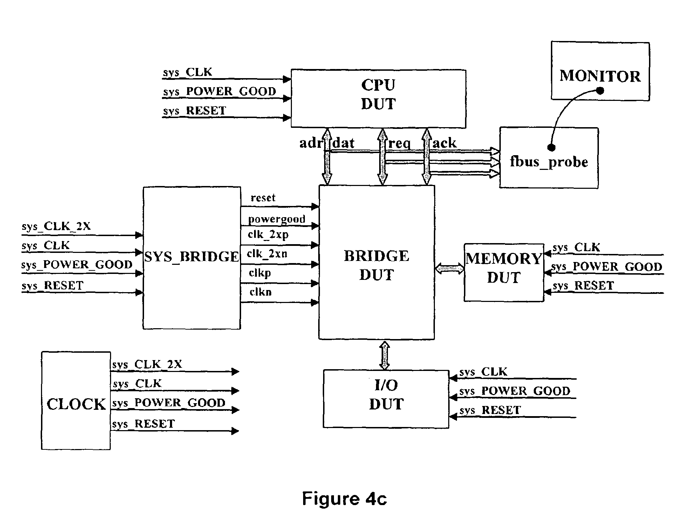

La figure 1 représente un exemple d'architecture d'un système comprenant un circuit intégré en développement, constitué d'un processeur (1) (CPU) communicant par une passerelle (4) (BRIDGE) avec une mémoire système (2) (MEMORY) et des entrées sorties (3) (I/O). Les figures 4a, 4b et 4c représentent trois modèles globaux de simulation de l'architecture de la figure 1, à des stades successifs d'un projet, les figures 4a et 4ab étant des exemples d'étapes intermédiaires d'évolution vers le modèle de la figure 4c, qui peut représenter un modèle global final. Chaque modèle global de simulation est généré par un utilisateur du système de reconnaissance automatique, manuellement ou par un générateur automatique de configurations, dit configurateur (17, figure 2), permettant de générer une configuration arbitraire à partir d'au moins un fichier comprenant les conditions de génération de la configuration (18). Le configurateur (17) est, par exemple, celui décrit dans la demande de brevet "Système et procédé d'établissement automatique d'un modèle global de simulation d'une architecture" déposée par la requérante ce même jour. Dans le mode de réalisation de la figure 2, les conditions de génération de la configuration (18) sont réparties sous forme de trois fichiers comprenant respectivement une description de l'architecture du modèle global de simulation (FDARCH), une description synthétique de la configuration à générer (FCONF) et une description des interfaces de type HDL des composants (BFSHDL).

L'utilisateur du système selon l'invention génère, manuellement ou à l'aide du configurateur (17), deux fichiers MGHDL (33) et MGHLL (32) qui vont servir de fichiers source pour la simulation. Le fichier MGHDL (33) instancie les parties HDL du modèle et décrit la connexion, en langage de type HDL, des composants entre eux, et le fichier MGHLL (32), contient des instances, écrites en langage de type HLL, comportant les caractéristiques de chaque composant.

Le système de reconnaissance automatique de configurations de simulation selon l'invention permet aux tests de vérifier leur adéquation à la configuration au cours de la simulation, et de s'adapter en fonction de la configuration, afin de ne pas avoir à écrire un test par variante de configuration.

Le modèle global représenté sur la figure 4b, auquel peut par exemple aboutir le configurateur, est constitué d'un composant processeur CPU de type XACTOR relié par une interface de type "fbus_p" à un bloc intermédiaire (fbus_xchg) (101) ayant une interface de type différent. Un autre bloc intermédiaire (fbus_xchg) (102) relie le premier bloc intermédiaire (101) à un composant de type passerelle (BRIDGE) de type DUT_CORE qui communique, d'une part avec un modèle majoritairement en langage de type HDL d'une mémoire (MEMORY) de type DUT, d'autre part avec un modèle majoritairement en langage de type HDL d'une entrée/sortie (I/O) de type DUT et enfin avec un bloc système (SYS_BRIDGE) de type DUT.

Chaque type de Composant peut être décrit à plusieurs niveaux de détails (fonctionnel, comportemental, portes, etc...) en langage de type HDL, tel que VERILOG ou VHDL, ou en langage de haut niveau (HLL), tel que C ou C++, complété d'une interface de type HDL. Plusieurs niveaux de descriptions peuvent coexister pour décrire des fonctionnalités similaires et avoir des interfaces de type HDL similaires mais pas forcément identiques. Certaines descriptions peuvent avoir plus de fonctionnalités, et les interfaces de type HDL peuvent contenir des jeux de signaux complètement différents.

Chaque instance d'un composant dans ce schéma obtient des paramètres d'identification du composant, à savoir au moins un nom ou label, qui identifie la position du composant (par exemple CPU_0, BRIDGE_0, CMEM_0), un type (par exemple DUT, VERIFIER, XACTOR, MONITOR) et un chemin HDL, correspondant au nom hiérarchique du composant dans le modèle global de simulation. Un exemple de définition des paramètres d'identification d'un composant est donné dans l'annexe 1.

Les composants sont décrits, comme représenté sur les figures 3a à 3c, à la fois en langage de type HDL et en langage de type HLL.

Dans le cas d'un composant décrit complètement en langage de type HDL (figure 3a), la partie de type HLL est réduite à une instance qui permet de signaler sa présence dans la configuration au cours de la simulation et qui fournit les chemins d'accès aux ressources de type HDL du composant. Dans le cas où un composant de type HDL n'a pas besoin d'être identifié par le test, la présence de la partie HLL est facultative, ce qui permet une simplification du modèle global de simulation.

Pour les composants décrits en langage de type HLL (figure 3c), c'est la partie de type HDL qui est réduite au strict minimum, et qui est limitée à la description des signaux et registres d'interface.

Tous les niveaux intermédiaires entre ces deux extrémités sont possibles et naturellement exploités dans le contexte de processus de développement des circuits ASIC.

La partie de type HLL des composants est construite par un constructeur d'instance. C'est cette partie qui comprend les paramètres d'identification du composant (nom, type, chemin HDL, etc...).

Un exemple d'instance d'identification d'un composant, écrite en C++, est donné dans l'annexe 4.

La figure 2 illustre le principe du procédé de reconnaissance automatique de configurations de simulation selon l'invention. Le fonctionnement du procédé de reconnaissance automatique de configurations sera décrit, de façon non limitative, dans une architecture client-serveur, comme représenté sur la figure 2. Le procédé de reconnaissance automatique de configurations fonctionne également sur une machine unique ou dans une architecture multiclients-multiserveurs, distribuée sur plusieurs machines, chaque machine comprenant au moins un serveur ou un client de l'architecture. L'utilisation d'une architecture client-serveur est particulièrement utile dans le cas où la mémoire de la machine constituant le serveur n'est pas suffisante pour réaliser le procédé.

Le modèle global de simulation est constitué de fichiers sources HDL et HLL (marqués respectivement MGHDL et MGHLL) et de toutes les bibliothèques de composants HDL (71) et modules de librairies HLL (72) auxquels ils font respectivement référence. Les deux parties du modèle global sont ensuite compilées pour donner les fichiers objet HDL (51) et fichiers objet HLL (52) utilisés par le simulateur. Les fichiers objets HLL sont intégrés au simulateur édition des liens (linking) en utilisant une API standardisé (exemple PLI pour VERILOG) et les fichiers objet HDL seront utilisés directement par le simulateur pour créer les modèles des composants. Le serveur (13) comprend un gestionnaire, dit ServerRegistry (14), qui comprend au moins une table m_plnstanceMap (15) mémorisant des informations sur l'instance. Le client (10) comprend également un gestionnaire, dit ClientRegistry (11), comprenant au moins une table m_serverConfigMap (12) dans laquelle sont mémorisées, au début du procédé de reconnaissance de configurations les informations sur les instances des composants présentes dans le modèle simulé

Au début de chaque simulation les constructeurs des instances d'objets sont appelés. Chaque constructeur appelle une procédure spéciale dite Register de la classe ServerRegistry (annexe 3) en lui transmettant les informations sur l'instance, ces informations sont mémorisées (16) dans la table m_plnstanceMap (15).

Le procédé selon l'invention permet au client de vérifier l'adéquation de chaque test de simulation fourni par le client avec la configuration à laquelle le test est associé.

Pour ce faire, le client (10) envoie une requête faisant partie de la classe QueryReq par l'intermédiaire du gestionnaire du client ClientRegistry (11) au gestionnaire du serveur ServerRegistry (14). Une interface programmatique API CONF, présente sur le serveur (13), permet de traduire la requête en langage compréhensible par le gestionnaire du serveur ServerRegistry (14). La requête QueryReq permet au client (10) de s'informer sur la présence d'un composant dans la configuration et sur son type. Le client (10) demande par exemple si tel type de composant est présent dans telle ou telle configuration, et, si oui, où il est. Le client (10) peut aussi lancer une requête pour s'informer sur la présence et le type de tous les éléments compris dans une ou plusieurs configurations, sur un ou plusieurs serveurs, en spécifiant comme paramètres (annexe 1, classe QueryReq) INSTANCE_ANY, TYPE_ANY et SERVER_ANY respectivement. Le gestionnaire du serveur ServerRegistry (14) cherche dans la table m_plnstanceMap (15) et envoie une réponse au gestionnaire du client ClientRegistry (11) par l'intermédiaire de l'API CONF, formulée par la classe QueryRsp. Un exemple de classe ServerRegistry du gestionnaire du serveur est donné en annexe 3. Si le gestionnaire du serveur ServerRegistry (14) trouve le type de composant cherché, il le notifie dans la réponse en précisant, en fonction de ce qui lui est demandé dans la requête, les informations comprises dans la requête associée à chaque composant. La réponse contient par exemple le nom (label), le type du composant, son chemin HDL, le nom de la configuration et le nom du serveur sur lequel il est simulé. Dans le cas où le composant recherché n'est pas présent dans la configuration, la réponse contient une notification d'erreur (INSTANCE_NONE, TYPE_NONE). Le gestionnaire du client ClientRegistry (11) mémorise alors la réponse dans la table m_serverConfigMap (12) formant un cache de la table du gestionnaire serveur. Un exemple de cette procédure est donné en annexe 2. Dans le cas d'une simulation muti-serveur la table du gestionnaire client contient la somme de contenu des tables de tous les serveurs utilisés. Dans ce cas le test utilise le nom du serveur associé à chaque composant pour adresser les stimuli vers le serveur adéquat. Si les composants et leur type correspondent aux attentes du test, le test s'auto-adapte à la configuration en inhibant, activant et/ou modifiant certaines parties du test selon la présence ou non des composants et leur type particulier. Ceci permet de pouvoir utiliser le même test pour des configurations différentes.

Le client (10) peut alors exécuter le test de simulation sur le serveur (13) par l'intermédiaire d'une interface programmatique API SIM, qui traduit le test en stimuli. L'annexe 5 illustre la définition des classes clientes permettant l'accès à l'API SIM correspondant à l'architecture représentée sur la figure 1. Si la configuration ne correspond pas aux besoins du test une erreur est signalée. Un exemple de test correspondant à l'architecture représentée sur la figure 1 est donné en annexe 6. Ce test ne peut s'exécuter correctement que si les composants suivants sont présents: CPU_0 d'un type arbitraire, CMEM_0 et/ou CIO_0 de type arbitraire et BRIDGE_0 de type DUT_CORE. Pour CPU_0 de type DUT un traitement spécifique est appliqué - appel de procédures self_test() et reset(). Dans la boucle principale du test les accès mémoire et entrée-sortie sont exécutés de manière conditionnelle selon la présence des composants CMEM_0 et CIO_0. Le test de l'annexe 6 correspond à la configuration de la figure 4b ou ses variantes. Les fichiers MGHLL et MGHDL correspondants, générés par le système configurateur automatique (17) sont donnés dans les annexes 7 et 8 respectivement.

On conçoit que la présente invention peut être mise en oeuvre selon d'autres formes spécifiques, sans sortir de son domaine d'application tel que revendiqué. Par conséquent, la présente description détaillée doit être considérée comme étant une simple illustration d'un cas particulier dans le cadre de l'invention et peut donc être modifiée sans sortir du domaine défini par les revendications jointes.

### ANNEXE 1

```
 /*++******************************************************************
 *
 * Copyright (c) 2000 BULL - Worldwide Information Systems
 * All rights reserved
 *
 * Module name : registry.hpp
 * Author : Andrzej Wozniak
 *
 *--*******************************************************************/

 #ifndef HPP_REGISTRY_HPP
 #define HPP_REGISTRY_HPP

 ///////////////////////////////////////////
 #include <map.h>
 #include <strstream>
 #include <string>
 //////////////////////////////////////////

 class LabelClass {
 public:
 enum InstLabel {
   //
   CPU_0 = 0x0010,
   CPU_1 = 0x0011,
   //
   BRIDGE_0 = 0x0020,
   BRIDGE_1 = 0x0021,
   //
   CMEM_0 = 0x0030,
   CMEM_1 = 0x0031,
   //
   CIO_0 = 0x0040,
   CIO_1 = 0x0041,
   //
   CPU_0_BRIDGE_0 = 0x2010,
   BRIDGE_0_CPU_0 = 0x1020,
   CPU_1_BRIDGE_1 = 0x2111,
   BRIDGE_1_CPU_1 = 0x1121,
   //
   INSTANCE_ANY = 0xffff,
   INSTANCE NONE = 0x0000
 };
 };
 /////
 class TypeClass {
 public:
 enum InstType {
   DUT = 0x0001,
  DUT_CORE                   = 0x0002,
  XACTOR                     = 0x0004,
  MONITOR                    = 0x0008,
  VERIFIER                   = 0x0010,
  FBUS_XCHG                  = 0x0020,
  //
  TYPE_ANY                    = 0xffff,
  TYPE_NONE                   = 0x0000
 };
 };
 /////

 class Registry : public LabelClass, public TypeClass {
 public:
 typedef long unsigned int Handle_t;
 public:
 static const string SERVER_ANY;
 static const int MAX_CLIENT_NB = 16;
 static const int MAX_SERVER_NB = 8;
 public:
 ////

 typedef long long unsigned int CombinedID_t;
 };
 ////

 class QueryReq : public Registry {
 public:
 QueryReq(const string& serverName = SERVER_ANY,
       int clientNum = 0,
       InstLabel instanceLabel = INSTANCE_ANY,
       InstType instanceType = TYPE_ANY);
 public:
  string m_serverName;
  int m_clientNum;
  InstLabel m_instanceLabel;
  InstType m_instanceType:
 }:

 class QueryRsp : public Registry {
 public:
 QueryRsp(long unsigned int iihandle = 0,
       const string& serverName = SERVER_ANY,
       InstLabel instanceLabel = INSTANCE_ANY,
       InstType instanceType = TYPE_ANY,
       const string& instanceName = string(""),
       const string& instanceVerilogPath = string(""));
 public:
 long unsigned int m_handle;
 string m_serverName;
 InstLabel m_instanceLabel;
 InstType m_instanceType;
 string m_instanceName;
 string m_instanceVerilogPath;
 string m_fullInstanceName;
 };

 class QueryError{
 public:
 const string m_err;
 QueryRsp m_qrsp;
 QueryError(const string& err, const QueryRsp& qrsp):
  m_err(err),
  m_qrsp(qrsp){ }
 };
 ////

 ostream& operator« (ostream& str, const QueryReq& qrq);
 istream& operator» (istream& str, QueryReq& qrq);

 ostream& operator« (ostream& str, const QueryRsp& qrsp);
 istream& operator» (istream& str, QueryRsp& qrsp);

 typedef int Status;

 #endif /* HPP_REGISTRY_HPP */
```

### ANNEXE 2

```
 /*++***********************************************************
 *
 * Copyright (c) 2000 BULL - Worldwide Information Systems
 * All rights reserved
 *
 * Module name : client_registry.hpp
 * Author : Andrzej Wozniak
 *
 *--*************************************************************/

 #ifndef HPP_CLIENT_REGISTRY_HPP
 #define HPP_CLIENT_REGISTRY_HPP

 #include <map>
 #include "registry.hpp"
 #include "client_component.hpp"

 class ClientRegistry : public Registry {
 public:
   typedef map<int, QueryRsp*> QueryMap_Type;
 public:
   static Status QueryServerConfig();
   static const QueryRsp& QueryServer(InstLabel iid, InstType
 ict) ;
   static const QueryMap_Type& getQueryMap();
   static QueryRsp& QueryComponent(InstLabel iid, InstType
 ict) ;
 private:
   static QueryMap_Type m_serverConfigMap;
   static QueryMap_Type::iterator m_it;
 public:
   static int getServerNumber();
   static int getClientOwnNum();
   static string& getConfigName();
 };

 #endif /* HPP_CLIENT_REGISTRY_HPP */
```

### ANNEXE 3

```
 /*++*********************************************************
 *
 * Copyright (c) 2000 BULL - Worldwide Information Systems
 * All rights reserved
 *
 * Module name : server_registry.hpp
 * Author : Andrzej Wozniak
 *
 *--**************************************************************/
 #ifndef HPP_SERVER_REGISTRY_HPP
 #define HPP_SERVER_REGISTRY_HPP

 #include "registry.hpp"
 #include "component.hpp"
 #include <map>

 class ServerRegistry : public Registry {
 public:
   static Status Register(ComponentIdent* p_comp);
   static ComponentIdent* getInstance(InstLabel ilabel,
 InstType itype);
   static const ComponentIdent* c_getInstance(InstLabel ilabel,
 InstType itype);
 public:
   static Status QueryServer();
 private:
   typedef map<CombinedID_t, ComponentIdent*> Map_t;
   static Map_t* m_pInstanceMap;
   static int m_clientNumber;
   static const string m_serverName;
   static const string m_configName;
 public:
   static const string& getServerName();
   static const string& getConfigName();
   static int getServerNumber();
   static int getClientNumber();
 public:
   //
 } ; // ServerRegistry class

 #endif /* HPP_SERVER_REGISTRY_HPP */
```

### ANNEXE 4

```
 /*++************************************************************
 *
 * Copyright (c) 2000 BULL - Worldwide Information Systems
 * All rights reserved
 *
 * Module name : Component.hpp
 * Author : Andrzej Wozniak
 *
 *--****************************************************************/

 #ifndef HPP_COMPONENT_HPP
 #define HPP_COMPONENT_HPP

 //////////////////////////////////
 #include <string>
 #include "registry.hpp"
 /////////////////////////////////

 class ComuonentIdent : public Registry {
 public:
   ComponentIdent(InstLabel ilabel, InstType itype,
           const string iname, const string hdlpath);
 virtual ∼ComponentIdent();
 public:
   InstLabel m_ilabel;
   InstType m_itype;
   string m_iname;
   string m_hdlpath;

 };

 #endif /* HPP_COMPONENT_HPP */
```

### ANNEXE 5

```
 /*++*****************************************************
 *
 * Copyright (c) 2000 BULL - Worldwide Information Systems
 * All rights reserved
 *
 * Module name : client_component.hpp
 * Author : Andrzej Wozniak
 *
 *--**********************************************************/

 #ifndef HPP_CLIENT_COMPONENT_HPP
 #define HPP_CLIENT_COMPONENT_HPP

 class ClientComponent {
 protected:
   ClientComponent();
 public:
   static ClientComponent* create(QueryRsp qrsp);
 public:
   virtual int mem_write(unsigned long long addr, unsigned long
 long data);
   virtual int mem_read_compare(unsigned long long addr,
 unsigned long long data);
   virtual int io_write(unsigned long long addr, unsigned long
 long data);
   virtual int io_read_compare(unsigned long long addr,
 unsigned long long data);
   virtual int self_test();
   virtual int reset();
   virtual int cache_clear();
   virtual int cache_flush();
   virtual int get_err_nbr();
 };

 int PrintError(const string msg);

 #endif /* HPP_CLIENT_COMPONENT_HPP */
```

### ANNEXE 6

```
 /*++***************************************************************
 *
 * Copyright (c) 2000 BULL - Worldwide Information Systems
 * All rights reserved
 *
 * Module name : example_test.cpp
 * Author : Andrzej Wozniak
 *
 *--*****************************************************************/

 #include "client_registry.hpp"

 int Test (int argc, char* argv[]) {
   //////////CONFIGURE SECTION/////////////////////
   ClientRegistry::QueryServerConfig();

   QueryRsp &qrs_cpu_0 =
 ClientRegistry::QueryComponent(LabelClass::CPU_0,TypeClass::TY
 PE_ANY);
   QueryRsp &qrs_mem_0 =
 ClientRegistry::QueryComponent(LabelClass::CMEM_0,TypeClass::T
 YPE_ANY);
   QueryRsp &qrs_cio_0 =
 ClientRegistry::QueryComponent(LabelClass::CIO_0,TypeClass::TY
 PE_ANY);
   QueryRsp &qrs_bridge_0 =
 ClientRegistry::QueryComponent(LabelClass::BRIDGE_0,
 TypeClass::DUT_CORE);

   int err_status = 0;
   if(qrs_cpu_0.m_instanceLabel == LabelClass::INSTANCE_NONE){
     PrintError("Component CPU_0 is missing\n");
     ++err status;
 }
 if(qrs_mem_0.m_instanceLabel == LabelClass::INSTANCE_ANY
   && qrs_cio_0.m_instanceLabel ==
 LabelClass::INSTANCE_ANY) {
   PrintError("Components MEM_0 and CIO_0 are both
 missing\n");
  ++err_status;
 }
 if(qrs_bridge_0.m_instanceType != TypeClass::DUT_CORE){
   PrintError("Component BRIDGE_0 of type DUT_CORE is
 missing\n");
  ++err_status;
 }
 if(err_status){
   PrintError("aborting test\n");
   return -1;
 }
 ///// constructing client components
 ClientComponent* cpu_0 = ClientComponent::create(qrs_cpu_0);
 ClientComponent* mem_0 = ClientComponent::create(qrs_mem_0);
 ClientComponent* cio_0 = ClientComponent::create(qrs_cio 0);
 ClientComponent* bridge_0 =
 ClientComponent::create(qrs_bridge_0);
 /////
 const int MAX_CYCLES = 4096;
 const unsigned long long mem_base = 0x8123456787665500ULL;
 const unsigned long long cio_base = 0xFFFFFFFFFABCD100ULL;

 if(qrs_cpu_0.m_instanceType == TypeClass::DUT){
  cpu_0->self_test();
  cpu_0->reset();
 }
 bridge_0->cache_clear();
 for(int ii; ii<MAX_CYCLES; ++ii){
  if(qrs_mem_0.m_instanceLabel != LabelClass::INSTANCE_ANY){
    cpu_0->mem_write(mem_base+8*ii,
 0xa5a5a5a5a5a50000ULL+ii);
   }
  if(qrs_cio_0.minstanceLabel != LabelClass::INSTANCE_ANY){
    cpu_0->io_write(cio_base+4*ii,
 0xc3c3c3c3c3c30000ULL+ii);
   }
 }
 bridge_0->cache_flush();
 for(int ii; ii<MAX_CYCLES; ++ii){
  if(qrs_mem_0.m_instanceLabel != LabelClass::INSTANCE_ANY){
    cpu_0->mem_read_compare(mem_base+8*ii,
 0xa5a5a5a5a5a50000ULL+ii);
   }
  if(qrs_cio_0.m_instanceLabel != LabelClass::INSTANCE_ANY){
    cpu_0->io_read_compare(cio_base+4*ii,
 0xc3c3c3c3c3c30000ULL+ii);
   }
 }

 return cpu_0->get_err_nbr() + mem_0->get_err_nbr() + cio_0-
 >get_err_nbr() + bridge_0->get_err_nbr();
 }
```

### ANNEXE 7

```
 ////////////////////////////////////
 // FILE GENERATED by A.W. PERL SCRIPT
 // FROM patent/sim/configs/pat03.cfg file
 // FOR server
 /////////////////////////////////////

 ////////////
 #include "server_registry.hpp"
 #include "server_components.hpp"

 /////////////

 const string ServerRegistry::m_serverName = "SERVER";
 const string ServerRegistry::m_configName = "pat03";
 const int ServerRegistry::m_serverNumber = 1;
 Status InstantiateConfiguration(){
 ///////////

 static Fbus_hwif CPU_0_XACTOR_FBUS_p (LabelClass::CPU_0,
 TypeClass::FBUS_type,
                    string("top.CPU_0_XACTOR_FBUS_p"));
 static Cio_Dut CIO_0 (LabelClass::CIO_0, TypeClass::DUT,
                     string("top.CIO_0"));
 static Cmem_Dut CMEM_0 (LabelClass::CMEM_0, TypeClass::DUT,
                     string("top.CMEM_0"));
 static Bridge_Dut BRIDGE_0 (LabelClass::BRIDGE_0,
 TypeClass::DUT_CORE,
                     string("top.BRIDGE_0"));
 static CPU_Xactor CPU_0_XACTOR (LabelClass::CPU_0,
 TypeClass::XACTOR,
                     &CPU_0_XACTOR_FBUS_p);
 static CPU_Monitor CPU_0_MONITOR (LabelClass::CPU_0,
 TypeClass::MONITOR,
                     &CPU_0_XACTOR_FBUS_p);
 static Fbus_Xchg BRIDGE_0_CPU_0_FBUS_XCHG
 (LabelClass::BRIDGE_0_CPU_0, TypeClass::FBUS_XCHG,
                     string("top.BRIDGE_0_CPU_0_FBUS_XCHG"));
 static Fbus_Xchg CPU_0_BRIDGE_0_FBUS_XCHG
 (LabelClass::CPU_0_BRIDGE_0, TypeClass: :FBUS_XCHG,
                     string("top.CPU_0_BRIDGE_0_FBUS_XCHG"));
    return Success;
 }
 //////////
 // END
 /////
```

### ANNEXE 8

```
 ////////////////////////////////////////////////////////////////////////////////////////////
 FILE "config_server_pat03_top.v" GENERATED by A.W. PERL SCRIPT
 // FROM "patent/sim/configs/pat03.cfg" file
 /////////////////////////////////////////////////////////////////////////////////////////////

 /////
 timescale 100ps
 /////
 module top ();

 wire POWER_GOOD;
 wire RESET;

 wire CLK_33MHz;
 wire CLK_66MHz;

 Clock SysClock(
        .sys_POWER_GOOD (POWER_GOOD)
        .sys_RESET (RESET),
        .sys_CLK (CLK_33MHz),
        .sys_CLK_2X (CLK_66MHz)

     /////
     ///// Wire Declaration Section
     /////
 // wire         CLK_33MHz;       // output(1)
 // wire         CLK_66MHz;       // input(3) output(1)
 // wire         POWER_GOOD;      // input(3) output(1)
 // wire         RESET;       // input(3) output(1)
 wire [3:0] W1_00_inXXack;    // input(1) output(1)
 wire [63:0]     W1_00_inXXadr_dat;     // input(1)
 output(1)
 wire [3:0] W1_00_inXXreq;   // input(1) output(1)
 wire [3:0] W1_00_outXXack;   // input(1) output(1)
 wire [63:0] W1_00_outXXadr_dat; // input(1)
 output(1)
 wire[3:0]\ W1_00_outXXreq; // input(1) output(1)
 wire [3:0] W_00_XXack; // inout(2)
 wire[63:0] W_00_XXadr_dat; // inout(2)
 wire [3.0] W_00_XXreq; // inout(2)
 wire [31:0] W_00_YYadr; // input(1) output(1)
 wire [2:0] W_00_YYctrl; // input(1) output(1)
 wire [63:0] W_00_YYdata; // inout(2)
 wire [1:0]W_00_ZZack; // input(1) output(1)
 wire [15:0] W_00_ZZdata; // inout(2)
 wire [1:0]W_00_ZZreq; // input(1) output(1)
     /////
 wire W_00_clk_2xn; // input(1) output(1)
 wire W_00_clk_2xp; // input(1) output(1)
 wire W_00_clkn; // input(1) output(1)
 wire W_00_clkp; // input(1) output(1)
 wire [3:0] W_00_inXXack; // input(1) output(1)
 wire[63:0] W_00_inXXadr_dat; // input(1)
 output(1)
 wire [3:0] W_00_inXXreq; // input(1) output(1)
 wire[3:0] W_00_outXXack; // input(1) output(1)
 wire[63:0] W_00_outXXadr_dat; // input(1)
 output(1)
 wire [3:0] W_00_outXXreq; // input(1) output(1)
 wire W_00_powergood; // input(1) output(1)
 wire W_00_reset; // input(1) output(1)

    ///////////////////////////////
    ///// Module Instancies Section
    ///////////////////////////////

 //// BRIDGE_0_CPU_0_FBUS_XCHG -> IND_CON -> FBUS_xchg
 //////////////////
 fbus_xchg BRIDGE_0_CPU_0_FBUS_XCHG (
           .XXadr_dat (W_00_XXadr_dat),
           .XXreq (W_00_XXreq),
           .XXack (W_00_XXack),
           .inXXadr_dat (W1_00_outXXadr_dat),
           .outXXadr_dat (W1_00_inXXadr_dat),
           .inXXreq (W1_00_outXXreq),
           .outXXreq (W1_00_inXXreq),
           .inXXack (W1_00_outXXack),
           .outXXack (W1_00_inXXack));

 //// CMEM_0 -> DUT -> CMEMD ////////////
 cmem CMEM_0 (
           .YYadr (W_00_YYadr),
           .YYdata (W_00_YYdata),
           .YYctrl (W_00_YYctrl),
           .clk (CLK_66MHz),
           .reset (RESET),
           .powergood (POWER_GOOD));

 //// CIO_0 -> DUT -> CIOD ////////////
 cio CIO_0 (
           .ZZdata (W_00_ZZdata),
           .ZZreq (W_00_ZZreq),
           .ZZack (W_00_ZZack),
           .clk (CLK_66MHz),
           .reset (RESET),
           .powergood (POWER_GOOD));

 //// BRIDGE_0 -> DUT_CORE -> BRD /////////////
 bridge_core BRIDGE_0 (
           .inXXadr_dat (W1_00_inXXadr_dat),
           .outXXadr_dat (W1_00_outXXadr_dat),
           .inXXreq (W1_00_inXXreq),
           .outXXreq (W1_00_outXXreq),
           .inXXack (W1_00_inXXack),
           .outXXack (W1_00_outXXack),
           .YYadr (W_00_YYadr),
           .YYdata (W_00_YYdata),
           .YYctrl (W_00_YYctrl),
           .ZZdata (W_00_ZZdata),
           .ZZreq (W_00_ZZreq),
           .ZZack (W_00_ZZack),
           .clk_2xp (W_00_clk_2xp),
           .clk_2xn (W_00_clk_2xn),
           .clkp (W_00_clkp),
           .clkn (W_00_clkn),
           .reset (W_00_reset),
           .powergood (M_00_powergood));

 //// CPU_0_BRIDGE_0_FBUS_XCHG -> IND_CON -> FBUS_xchg
 /////////////
 fbus_xchg CPU_0_BRIDGE_0_FBUS_XCHG (
           .XXadr_dat (W_00_XXadr_dat),
           .XXreq (W_00_XXreq),
           .XXack (W_00_XXack),
           .inXXadr_dat (W_00_outXXadr_dat),
           .outXXadr_dat (W_00_inXXadr_dat),
           .inXXreq (W_00_outXXreq),
           .outXXreq (W_00_inXXreq),
           .inXXack (W_00_outXXack),
           .outXXack (W_00_inXXack));

 //// CPU_0 -> XACTOR -> FBUS_p //////////
 fbus_p CPU_0_XACTOR_FBUS_p (
           .inXXadr_dat (W_00_inXXadr_dat),
           .outXXadr_dat (W_00_outXXadr_dat),
           .inXXreq (W_00_inXXreq),
           .outXXreq (W_00_outXXreq),
           .inXXack (W_00_inXXack),
           .outXXack (W_00_outXXack),
           .clk (CLK_66MHz),
           .reset (RESET),
           .powergood (POWER_GOOD));

 //// BRIDGE_0_sys -> SYS_CON -> BRIDGE_sys //////////
 sys_bridge #(0, 32'h00000007) BRIDGE_0_sys (
           .clk_2xp (W_00_clk_2xp),
           .clk_2xn (W_00_clk_2xn),
           .clkp (W_00_clkp),
           .clkn (W_00_clkn),
           .reset (W_00_reset),
           .powergood (W_00_powergood),
           .sys_CLK_2X (CLK_66MHz),
           .sys_CLK (CLK_33MHz),
           .sys_RESET (RESET),
           .sys_POWER_GOOD (POMER_GOOD));
 endmodule

 /////
 // END
 /////
```

## Revendications

1. Procédé de reconnaissance automatique de configurations de simulation disponibles de circuits intégrés en projet comprenant au moins deux composants reliés entre eux directement ou indirectement, pour la vérification fonctionnelle desdits circuits par des tests de simulation, **caractérisé en ce qu'**il comprend :
- une étape de saisie de configuration de simulation par un premier gestionnaire, appelé "gestionnaire serveur" (14) associé à un programme simulateur, pendant l'initialisation du programme simulateur, et pendant que sont alors appelés tous les constructeurs d'instances HLL (High-Level programming Language) de composants présents dans le modèle global de simulation courant, chacun de ces constructeurs enregistrant sa présence en transmettant ses propres paramètres, à savoir au moins un nom ou un label qui identifie la position du composant, un type et un chemin H.D.L. (Hardware Description Language) qui correspond au nom hiérarchique du composant dans le modèle global de simulation, au gestionnaire serveur qui construit la table des instances des composants,
- une étape d'envoi d'une requête par un deuxième gestionnaire, appelé "gestionnaire client" (11) vers le gestionnaire serveur (14) pour savoir si les composants attendus dans une configuration par le gestionnaire client (11) sont présents et quelles sont leurs positions, indiquées par leurs labels respectifs, et leurs types,
- une étape d'envoi d'une réponse par le gestionnaire serveur (14) au gestionnaire client (11), après consultation de la table des instances des composants, la réponse contenant les instances des composants présents et/ou une notification d'erreur en cas d'absence d'un ou plusieurs composants attendus, et de mémorisation de la réponse dans au moins une table de mémorisation des modèles de configuration (12) par le gestionnaire client,
- une étape de comparaison, par le gestionnaire client (11), de la réponse avec les exigences du test, suivie d'une étape d'inhibition, d'activation et/ou de modification de certaines parties du test par le gestionnaire client (11) pour adapter le test à la configuration ou signalisation d'erreur si cela s'avère impossible.

2. Procédé de reconnaissance automatique de configurations selon la revendication 1, **caractérisé en ce que,** au préalable, le procédé comprend une étape de génération des configurations de simulation à partir des données de génération de configurations (MGHLL, MGHDL).

3. Procédé de reconnaissance automatique de configurations selon la revendication 2, **caractérisé en ce que** la génération des configurations de simulation est réalisée par un opérateur.

4. Procédé de reconnaissance automatique de configurations selon la revendication 2, **caractérisé en ce que** la génération des configurations de simulation est réalisée par un générateur automatique de configurations (17).

5. Procédé de reconnaissance automatique de configurations selon une des revendications 1 à 4, **caractérisé en ce que** l'étape d'envoi d'une requête est suivie d'une étape de traduction de ladite requête, par une interface programmatique (API CONF), en langage compréhensible par le premier gestionnaire (14), et **en ce que** l'étape d'envoi d'une réponse est suivie d'une étape de traduction de ladite réponse, par l'interface programmatique (API CONF), en langage compréhensible par le deuxième gestionnaire (11).

6. Procédé de reconnaissance automatique de configurations selon une des revendications 1 à 5, **caractérisé en ce qu'**il fonctionne dans une architecture client-serveur, le premier gestionnaire (11) étant situé sur le serveur (10) et le deuxième gestionnaire (14) sur le client (13).

7. Système de reconnaissance automatique de configurations de simulation disponibles de circuits intégrés en projet adapté pour mettre en oeuvre le procédé selon l'une des revendications 1 à 6, **caractérisé en ce qu'**il comprend :
- un premier gestionnaire (14), dit « gestionnaire serveur », muni :
• de moyens de saisie de configuration de simulation et associé à un programme simulateur, ainsi que
• des moyens de réception des paramètres propres à chaque constructeur d'instances H.L.L. de composants présents dans le modèle global de simulation courant et destinés à être enregistrés dans une table des instances des composants et
• des moyens de réception et d'envoi de réponses à au moins un message et/ou une requête provenant d'un second gestionnaire (11),
- le second gestionnaire (11), dit « gestionnaire client », qui intègre:
• des moyens de formulation et d'envoi d'au moins un message et/ou d'au moins une requête de renseignement sur la présence et les paramètres de composants attendus au niveau du premier gestionnaire pour une configuration par le gestionnaire client,
• des moyens de construction et de consultation de ladite table des instances des composants,
• des moyens de mémorisation dans au moins une table de mémorisation des modèles de configuration d'au moins une réponse provenant du gestionnaire serveur, ainsi que
• des moyens d'inhibition, d'activation et/ou de modification de certaines parties du test afin d'adapter le test en fonction de la réponse.

## Claims

1. Method for automatic recognition of available simulation configurations of integrated circuits at the project stage comprising at least two components directly or indirectly connected to each other, for the functional verification of said circuits by simulation tests, **characterised in that** it comprises:
- a step of the capture of a simulation configuration by a first manager, known as a "server manager" (14) associated with a simulator program, during the initialisation of the simulator program, and while all the constructors of HLL (High-Level programming Language) instances of components present in the current global simulation model are then called, each of these constructors registering its presence by transmitting its own parameters, namely at least one name or label that identifies the position of the component, a type and an HDL (Hardware Description Language) path that corresponds to the hierarchical name of the component in the global simulation model, to the server manager that is building the instance table of the components,
- a step of the sending of a request by a second manager, known as a "client manager" (11) to the server manager (14) in order to find out whether the components expected in a configuration by the client manager (11) are present and what their positions (indicated by their respective labels) and their types are,
- a step of the sending of a response by the server manager (14) to the client manager (11), after consulting the instance table of the components, the response containing the instances of the components present and/or an error notification in the event of the absence of one or more expected components, and for the storage of the response in at least one configuration model storage table (12) by the client manager,
- a step of comparison, by the client manager (11), of the response with the requirements of the test, followed by a step of the disabling, activation and/or modification of certain parts of the test by the client manager (11) in order to adapt the test to the configuration or indication of error if that proves impossible.

2. Method for automatic recognition of configurations according to Claim 1, **characterised in that,** beforehand, the method comprises a step of generation of the simulation configurations from the configuration generation data (MGHLL, MGHDL).

3. Method for automatic recognition of configurations according to Claim 2, **characterised in that** the generation of the simulation configurations is performed by an operator.

4. Method for automatic recognition of configurations according to Claim 2, **characterised in that** the generation of the simulation configurations is performed by an automatic configuration generator (17).

5. Method for automatic recognition of configurations according to one of Claims 1 to 4, **characterised in that** the step of sending a request is followed by a step of translation of said request, by a programming interface (API CONF), into language understandable by the first manager (14), and **in that** the step of sending a response is followed by a step of translation of said response, by the programming interface (API CONF), into language understandable by the second manager (11).

6. Method for automatic recognition of configurations according to one of Claims 1 to 5, **characterised in that** it operates in a client-server architecture, the first manager (11) being located in the server (10) and the second manager (14) in the client (13).

7. System for automatic recognition of available simulation configurations of integrated circuits at the project stage for implementing the method according to one of Claims 1 to 6, **characterised in that** it comprises
- a first manager (14), known as "server manager", provided with
• means for capturing a simulation configuration and associated with a simulator program, together with
• means for receiving the parameters specific to each constructor of HLL instances of components present in the current global simulation model and intended to be recorded in an instance table of the components and
• means for receiving and sending the responses to at least one message and/or request coming from a second manager (11),
- the second manager (11), known as a "client manager", which incorporates:
• means for formulation and sending at least one message and/or at least one request for information on the presence and parameters of components expected at the first manager for configuration by the client manager,
• means for constructing and consulting said instance table of the components,
• means for storing, in at least one configuration model storage table, at least one response from the server manager, together with
• means for disabling, activating and/or modifying certain parts of the test so as to adapt the test as a function of the response.

## Patentansprüche

1. Verfahren zum automatischen Erkennen von verfügbaren Simulationskonfigurationen von Entwürfen integrierter Schaltungen, die wenigstens zwei direkt oder indirekt miteinander verbundene Komponenten besitzen, um die Funktion der Schaltungen durch Simulationstests zu verifizieren,
**dadurch gekennzeichnet, dass** es umfasst:
- einen Schritt zum Erfassen der Simulationskonfiguration durch einen ersten Manager, der "Server-Manager" (14) genannt wird und dem ein Simulationsprogramm zugeordnet ist, während der Initialisierung des Simulationsprogramms, währenddessen alle Konstrukteure von Instanzen HLL (High-Level Programming Language) von Komponenten, die in dem momentanen globalen Simulationsmodell vorhanden sind, bezeichnet werden, wobei jeder dieser Konstrukteure seine Gegenwart durch Übertragen seiner eigenen Parameter, d. h. wenigstens eines Namens oder eines Etiketts, das die Position der Komponente identifiziert, eines Typs und eines Wegs HDL (Hardware Description Language), der dem hierarchischen Namen der Komponente in dem globalen Simulationsmodell entspricht, an den Server-Manager, der die Tabelle der Instanzen der Komponenten konstruiert, einträgt,
- einen Schritt zum Schicken einer Anforderung durch einen zweiten Manager, der "Client-Manager" (11) genannt wird, zu dem Server-Manager (14), um zu erfahren, ob die von dem Client-Manager (11) in einer Konfiguration erwarteten Komponenten vorhanden sind und welches ihre Positionen, die durch ihre jeweiligen Etiketten angegeben werden, und ihre Typen sind,
- einen Schritt zum Schicken einer Antwort durch den Server-Manager (14) zu dem Client-Manager (11) nach der Abfrage der Tabelle der Instanzen der Komponenten, wobei die Antwort die Instanzen der vorhandenen Komponenten und/oder eine Fehlermeldung im Fall des Fehlens einer oder mehrerer erwarteter Komponenten enthält, und zum Speichern der Antwort in wenigstens einer Tabelle zum Speichern von Konfigurationsmodellen (12) durch den Client-Manager,
- einen Schritt zum Vergleichen der Antwort mit den Testanforderungen durch den Client-Manager (11), gefolgt von einem Schritt zum Verhindern, Aktivieren und/oder Modifizieren bestimmter Teile des Tests durch den Client-Manager (11), um den Test an die Konfiguration anzupassen oder einen Fehler zu melden, wenn sich dies als unmöglich erweist.

2. Verfahren zum automatischen Erkennen von Konfigurationen nach Anspruch 1, **dadurch gekennzeichnet, dass** das Verfahren vorher einen Schritt zum Erzeugen von Simulationskonfigurationen anhand von Konfigurationserzeugungsdaten (MGHLL, MGHDL) umfasst.

3. Verfahren zum automatischen Erkennen von Konfigurationen nach Anspruch 2, **dadurch gekennzeichnet, dass** die Erzeugung von Simulationskonfigurationen durch eine Bedienungsperson ausgeführt wird.

4. Verfahren zum automatischen Erkennen von Konfigurationen nach Anspruch 2, **dadurch gekennzeichnet, dass** die Erzeugung von Simulationskonfigurationen durch einen automatischen Konfigurationsgenerator (17) ausgeführt wird.

5. Verfahren zum automatischen Erkennen von Konfigurationen nach einem der Ansprüche 1 bis 4, **dadurch gekennzeichnet, dass** dem Schritt zum Schicken einer Anforderung ein Schritt zum Übersetzen der Anforderung durch eine programmartige Schnittstelle (API CONF) in eine für den ersten Manager (14) verständliche Sprache folgt und dass dem Schritt zum Schicken einer Antwort ein Schritt zum Übersetzen der Antwort durch die programmartige Schnittstelle API CONF in eine für den zweiten Manager (11) verständliche Sprache folgt.

6. Verfahren zum automatischen Erkennen von Konfigurationen nach einem der Ansprüche 1 bis 5, **dadurch gekennzeichnet, dass** es in einer Client-Server-Architektur arbeitet, wobei der erste Manager (11) sich in dem Server (10) befindet und der zweite Manager (14) sich in dem Client (13) befindet.

7. System zum automatischen Erkennen von verfügbaren Simulationskonfigurationen in Entwürfen von integrierten Schaltungen, das dazu ausgelegt ist, das Verfahren nach einem der Ansprüche 1 bis 6 auszuführen, **dadurch gekennzeichnet, dass** es umfasst:
- einen ersten Manager (14), der "Server-Manager" genannt wird und versehen ist mit:
- Mitteln zum Erfassen von Simulationskonfigurationen, denen ein Simulationsprogramm zugeordnet ist, sowie
- Mitteln zum Empfangen von Parametern, die zu jedem Konstrukteur von Instanzen HLL von Komponenten gehören, die in dem momentanen globalen Simulationsmodell vorhanden sind und dazu bestimmt sind, in eine Tabelle der Instanzen der Komponenten eingetragen zu werden, und
- Mitteln zum Empfangen und Schicken von Antworten auf wenigstens eine Nachricht und/oder eine Anforderung, die von einem zweiten Manager (11) stammt,
- den zweiten Manager (11), der "Client-Manager" genannt wird und in dem integriert sind:
- Mittel zum Formulieren und Schicken wenigstens einer Nachricht und/oder wenigstens einer Anforderung einer Auskunft bezüglich des Vorhandenseins und der Parameter von Komponenten, die auf Seiten des ersten Managers für eine Konfiguration durch den Client-Manager erwartet werden,
- Mittel zum Konstruieren und Abfragen der Tabelle der Instanzen der Komponenten,
- Mittel zum Speichern wenigstens einer Antwort, die von dem Server-Manager stammt, in einer Tabelle zum Speichern von Konfigurationsmodellen, und
- Mittel zum Verhindern, Aktivieren und/oder Modifizieren bestimmter Teile des Tests, um den Test als Funktion der Antwort anzupassen.
